(19) **Europäisches Patentamt**
**European Patent Office**
**Office européen des brevets**

(11) **EP 1 622 795 B1**

(12) **EUROPÄISCHE PATENTSCHRIFT**

(45) Veröffentlichungstag und Bekanntmachung des Hinweises auf die Patenterteilung:
**11.07.2007 Patentblatt 2007/28**

(21) Anmeldenummer: **04716211.0**

(22) Anmeldetag: **02.03.2004**

(51) Int Cl.:
**B60R 21/01** *(2006.01)*  **G01R 31/28** *(2006.01)*

(86) Internationale Anmeldenummer:
**PCT/DE2004/000400**

(87) Internationale Veröffentlichungsnummer:
**WO 2004/096613 (11.11.2004 Gazette 2004/46)**

(54) **VORRICHTUNG UND VERFAHREN ZUR ÜBERWACHUNG WENIGSTENS EINES ENERGIERESERVEKONDENSATORS IN EINEM RÜCKHALTESYSTEM**

DEVICE AND METHOD FOR MONITORING AT LEAST ONE ENERGY RESERVE CAPACITOR IN A RESTRAINT SYSTEM

DISPOSITIF ET PROCEDE DE CONTROLE D'AU MOINS UN CONDENSATEUR DE RESERVE D'ENERGIE DANS UN SYSTEME DE RETENUE

(84) Benannte Vertragsstaaten:
**DE ES FR GB SE**

(30) Priorität: **30.04.2003 DE 10319336**

(43) Veröffentlichungstag der Anmeldung:
**08.02.2006 Patentblatt 2006/06**

(73) Patentinhaber: **ROBERT BOSCH GMBH**
**70442 Stuttgart (DE)**

(72) Erfinder:
• **SCHUMACHER, Hartmut**
**71691 Freiberg (DE)**
• **HEILMANN, Gernod**
**71282 Hemmingen (DE)**

(56) Entgegenhaltungen:
**DE-A- 10 118 299**    **DE-A- 19 709 234**
**DE-U- 20 005 783**

EP 1 622 795 B1

**Beschreibung**

Die Erfindung geht aus von einem Verfahren bzw. einer Vorrichtung zur Überwachung wenigstens eines Energiereservekondensators in einem Rückhaltesystem nach der Gattung der unabhängigen Patentansprüche.

Aus DE 197 15 571 A1 ist es beispielsweise bekannt, die Kapazität eines Kondensators, der als Energiereserve für ein Rückhaltesystem verwendet wird, zu überwachen.

Aus DE 101 18 299 A1 ist ein Verfahren zur Überwachung des Innenwiderstands eines Energiereservekondensators bekannt. Dabei wird die Spannungsdifferenz zwischen einem sprunghaften Anstieg der Spannung am Energiereservekondensator zu Beginn der Ladephase und der Spannung am Ende der Ladephase sowie der Ladestrom verwendet. Aus DE 200 05 783 U1 ist es bekannt, den Innenwiderstand eines Energiereservekondensators durch die Belastung eines aufgeladenen Energiereservekondensators mittels eines Prüfstroms zu bestimmen. Diese Belastung führt zu einem Abfall der Spannung, so dass aus dem Abfall der Spannung und dem Prüfstrom der Innenwiderstand des Energiereservekondensators bestimmt werden kann.

Vorteile der Erfindung

Gemäß den Merkmalen der unabhängigen Patentansprüche ergeben sich die Vorteile des erfindungsgemäßen Verfahrens bzw. der erfindungsgemäßen Vorrichtung zur Überwachung eines Energiereservekondensators.

Mit der Alterung von Aluminiumelektrolytkondensatoren, die meist als Energiereservekondensatoren verwendet werden, geht eine Veränderung der Kapazität wie auch des Innenwiderstandes einher. Mit zunehmender Zahl von Zündkreisen, die immer häufiger parallel und mit hohem Strom gezündet werden müssen, verlieren derzeitige Lösungen von Energiereservespannung und Fahrzeugbatteriespannung an Wirksamkeit, da über eine Kabelverbindung mit 0,5 bis 1 Ohm Innenwiderstand nicht ausreichend genug Strom ohne merklichen Spannungseinbruch bereitgestellt werden kann. Aus diesem Grund wird es immer bedeutsamer, neben der Kapazität von den Energiereservekondensatoren auch deren Innenwiderstand gesondert zu überwachen. Nur dadurch kann im schlechtesten Fall sichergestellt werden, dass eine zeitgleiche parallele Zündung mit hoher Zündgeschwindigkeit und hohem Zündstrom erfolgen kann. Insbesondere bei Zündkreisen mit einem höheren Kreiswiderstand, beispielsweise 6,5 Ohm. Außerdem wird dabei sichergestellt, dass bei gleichzeitiger Verwendung des Energiespeichers zur Steuergeräteversorgung durch die hohe Stromentnahme beim Zünden bis zu 20 Ampere es nicht zu einem temporären Einbruch der Energiereservespannung unter die Resetschwelle der Spannungsversorgung kommt, was zu einem Versagen des gesamten Systems im Crashfalle führen würde. Wird ein Fehler, also ein zu hoher Innenwiderstand, erkannt, dann wird dies zur Anzeige gebracht, damit das Steuergerät mit dieser Energiereserve ausgetauscht werden kann. Denn dies ist nur notwendig, um den sicheren Betrieb von Rückhaltemittel im Auslösefall zu garantieren.

Derzeit wird bei der Elektronik für Rückhaltesysteme, insbesondere im Steuergerät, zur Zündung der Rückhaltemittel eine Energiereserve verwendet, für die entweder ein oder mehrere Kondensatoren verwendet werden. Damit ist die Zündung der Rückhaltemittel unabhängig von Schwankungen und dem Zustand der Batteriespannung im Fahrzeug. Die erfindungsgemäße Vorrichtung bzw. das erfindungsgemäße Verfahren ist sowohl bei einem Energiereservekondensator oder bei einer Mehrzahl von Energiereservekondensatoren anwendbar.

Das Verfahren zur Bestimmung des Innenwiderstands des Energiereservekondensators kann folgendermaßen ablaufen:

In einem ersten Schritt wird der Kondensator durch den Spannungswandler auf einen ersten Spannungswert aufgeladen, der über der Batteriespannung liegt. Dies ist notwendig, um die Messung oberhalb der Batteriespannung durchzuführen, da es sein kann, dass die Batteriespannung als Reserve direkt mit dem Energiereservekondensator gekoppelt ist und so gegebenenfalls die Messung verfälschen könnte. Wird jedoch der Energiereservekondensator über die Batteriespannung geladen, ist die Messung unabhängig vom Verhalten der Batteriespannung. Zur Schaffung definierter Anfangsbedingungen wird der Wandler abgeschaltet und es kommt zu einem abrupten Absinken der Spannung über den Innenwiderstand des Elektrolytkondensators. Diese Spannung muss dann aber über einem anderen Bauelement im Stromkreis abfallen. Dazu dienen zum einen der Kondensator des Spitzenwertgleichrichters und der Spannungsteiler, der dem Spitzenwertgleichrichter nachgeschaltet ist. Dieses Verhalten geschieht jedoch nicht instantan, sondern mit einer gewissen Zeitverzögerung, so dass für eine bestimmte Zeit gewartet wird, dass sich ein statischer Wert einpendelt. Diese Zeit wird im wesentlichen bestimmt durch den Abbau der Energie in der Spule des Schaltwandlers, der Zeitkonstanten des Spitzenwertgleichrichters, des Messtiefpasses sowie vorhandener Lastströme am Ausgang des Spitzenwertgleichrichters. Der Wert der Spannung, welche über dem Innenwiderstand des Energiereservekondensators zum Zeitpunkt des Abschaltens abfällt, ergibt sich aus dem Wert des Innenwiderstands und dem Ladestrom zu diesem Zeitpunkt, wobei der Ladestrom an den Kondensator abgegeben wurde. Nach dieser Wartezeit, bis sich der statische Wert eingependelt hat, wird erneut der Energiereservekondensator durch den Wandler aufgeladen. Durch die geänderte zeitliche Betrachtung bleibt der Ladezustand des Energiereservekondensators nahezu unverändert, während die Spannung über dem Energiereservekondensator im Takt des Schaltwandlers pulsiert. Die Spannung $u_x$ am Ausgang des

Spitzenwertgleichrichters nimmt den Spitzenwert der pulsierenden Spannung an. Danach wird der Wandler wieder abgeschaltet, bis sich ein statischer Wert gebildet hat. Wie oben dargestellt, kann aus der Differenz zwischen dem aufgeladenen Wert und dem statischen abgesunkenen Wert des Spitzenwertgleichrichters der Innenwiderstand des Energiereservekondensators ermittelt werden.

Die Zeit für die der Wandler abgeschaltet wird, wird in Abhängigkeit von der Spulenrestenergie, der Zeitkonstanten des Spitzenwertgleichrichters, des Messtiefpasses sowie vorhandener Lastströme am Ausgang des Spitzenwertgleichrichters gewählt. Die Ladezeit beim zweiten Laden wird derart gewählt, dass die Kapazität des Spitzenwertgleichrichters auf den Spitzenwert, der durch die durch den getakteten Ladestrom verursachten zweiten Spannung am Innenwiderstand des Energiereservekondensators zuzüglich der Spannung an der eigentlichen Kapazität angehoben wird. Das erfindungsgemäße Verfahren wird vorzugsweise beim Kaltstart durchgeführt, da in Bezug auf den Elektrolytkondensator sich das Fahrzeug im kältesten Zustand befindet.

Der Spannungswandler lädt den Energiereservekondensator getaktet auf. Zur Bestimmung des Innenwiderstands des Energiereservekondensators ist ein Schaltwandlerbetrieb mit bekannter Pulsstromamplitude notwendig, um aus der beobachteten Spannungsdifferenz zwischen Spitzenwert, wenn der Wandler aktiv ist, und dem abgesunkenen Wert, wenn der Wandler inaktiv ist, den Innenwiderstand des Energiereservekondensators zu bestimmen. Der Schaltwandlerbetrieb ist notwendig, da die Spannung an der Energiereserve und damit der gesamte Messvorgang über der Fahrzeugbatteriespannung liegt. Der hier verwendete getaktete Aufwärtswandler bestimmt den Spitzenwert des Spulenstroms im Querzweig des Wandlers.

Durch die in den abhängigen Ansprüchen aufgeführten Maßnahmen und Weiterbildungen sind vorteilhafte Verbesserungen der in den unabhängigen Patentansprüchen angegebenen Vorrichtung bzw. Verfahren zur Überwachung wenigstens eines Energiereservekondensators möglich.

Besonders vorteilhaft ist, dass die Vorrichtung durch eine zeitliche Abfolge wenigstens eines Ladevorgangs und einer Unterbrechung dieses Vorgangs den Innenwiderstand des Energiereservekondensators bestimmt. Damit können nämlich definierte elektrische Parameter ermittelt werden, die durch den Innenwiderstand beeinflusst werden. Damit ist es dann folglich möglich, den Innenwiderstand durch den Mikrokontroller im Steuergerät zu bestimmen. Wird eine Mehrzahl von Lade- und Entladevorgängen verwendet, ist die Messung robuster.

Weiterhin ist es von Vorteil, dass zur Überwachung des Innenwiderstands ein Spannungswandler, ein Gleichrichter und ein Spannungsteiler vorgesehen sind. Dabei dient der Spannungswandler zum Laden des wenigstens einen Energiereservekondensators und der dem Energiereservekondensator nachgeschaltete Gleichrichter und Spannungsteiler zum Messen der elektrischen Parameter, die zur Bestimmung des Innenwiderstands des Energiereservekondensators dienen. Der Gleichrichter muss ein Spitzenwertgleichrichter sein, während der Spannungsteiler zusätzlich als Tiefpass konfiguriert ist. Damit wird verhindert, dass kurzfristige Spannungsspitzen Einfluss auf die Messung nehmen. Der Spannungswandler weist vorzugsweise eine Regelung für seine Ausgangsspannung auf, um nach einer Ladephase des Energiereservekondensators die Ausgangsspannung in einem definierten Regelband zu halten.

In einer Weiterbildung ist vorgesehen, dass ein Längstransistor im Spannungswandler vorgesehen ist. Dieser Längstransistor ermöglicht die Steuerung des Durchgriffs der Batteriespannung auf den Energiereservekondensator. Dies senkt die Verlustleistung während der Messung, da bei einer niedrigeren Spannung gemessen werden kann.

Weiterhin kann durch Sperrung des Längstransistors während der Messung der Einfluss der Batteriespannung auf die Messung eliminiert werden.

Zeichnung

Ausführungsbeispiele der Erfindung sind in der Zeichnung dargestellt und werden in der nachfolgenden Beschreibung näher erläutert.

Es zeigen

Figur 1    ein erstes Schaltbild der erfindungsgemäßen Vorrichtung,
Figur 2    ein Spannungs-Zeit-Diagramm des Lade- und Entladevorgangs des Energiereservekondensators,
Figur 3    ein Flussdiagramm des erfindungsgemäßen Verfahrens,
Figur 4    ein Blockschaltbild der erfindungsgemäßen Vorrichtung und
Figur 5    ein zweites Schaltbild der erfindungsgemäßen Vorrichtung.

Beschreibung

Im Folgenden wird beschrieben, wie bei steigendem Innenwiderstand des Energiereservekondensators das Rückhaltesystem richtig reagiert, indem es bei einem gefährlich hohen Innenwiderstand dies zur Anzeige bringt, um einen Austausch der Elektronik zu erreichen. Das Signal kann beispielsweise im Armaturenbrett durch eine Anzeige dem Fahrer visuell dargebracht werden, es kann eine akustische Ausgabe erfolgen oder es kann auch zusätzlich eine Kontaktaufnahme über eine Sende-Empfangsstation, beispielsweise ein Mobiltelefon stattfinden, um eine Werkstatt oder eine andere Serviceeinrichtung zu kontaktieren. Diese könnte dann den Fahrer informieren, dass ein Austausch nunmehr notwendig ist.

Für die Durchführung bzw. die Realisierung der erfindungsgemäßen Vorrichtung sind folgende Voraussetzungen zu erfüllen:

Es ist ein getakteter Aufwärtswandler mit fester oder variabler Schaltwandlerfrequenz vorzusehen. Die Ladespannung des Energiereservekondensators muss letztlich über der höchsten Airbag-System-Versorgungsspannung liegen. Damit wird die Messung in einem Bereich durchgeführt, der durch andere Größen nicht gestört werden kann. Im Folgenden wird ein Wandler mit einer Spule gezeigt. Der Wandler muss eine Erfassung des Spulenstroms im Querzweig aufweisen, um nach dem Erreichen des maximal zulässigen Spulenstroms auf den Längszweig umzuschalten. Der maximale Spulenstrom im getakteten Ladebetrieb der Energiereserve sollte zwischen 0,4 und 1,2 A liegen. Dieser Wertebereich ist typisch, um in mittleren bis größeren Airbagsystemen auch große Energiereserven bis zu 20 mF in Zeiten von < 10 Sekunden auf $33 \pm 2$ Volt zu laden. Ist das der Fall, dann können Innenwiderstände des Energiereservekondensators mit einer Auflösung von 32 bis 96 m$\Omega$ aufgelöst werden. Es sind natürlich auch größere Spulenströme mit weiter verbesserter Auflösung der Messung des Innenwiderstands möglich.

Der Wandler muss durch einen Prozessor bzw. Mikrokontroller des Airbagsteuergeräts an- und ausschaltbar sein. Der Energiereserve muss ein Spitzenwertgleichrichter bestehend aus einer Diode und beispielsweise einem Keramikkondensator nachgeschaltet sein. Die Diode und der Keramikkondensator stellen in optimal ausgelegten Airbagsystemen keine Neuteile dar, sondern sind in aller Regel bereits vorhanden, um die Endstufen von Rückhaltesystemen mit der Energiereserve zu verbinden. D.h. dieser Spitzenwertgleichrichter ist so wie so vorhanden. Die Spannung des Spitzenwertgleichrichters des Energiereservekondensators muss über einen Spannungsteiler, der entweder diskret zwischen Diode und Masse liegt, oder der in einer integrierten Schaltung, zum Beispiel dem Endstufen-IC integriert wurde und als Tiefpassfilter beschaltet ist, geteilt werden. Das Tiefpassfilter entsteht entweder durch eine diskrete Keramik zwischen den beiden Teilwiderständen und Masse, oder das Tiefpassfilter entsteht durch eine entsprechende Beschaltung eines Operationsverstärkers zur Erfassung der Teilerspannung, beispielsweise integriert in den Endstufen-IC's. Die Spannung des Spitzenwertgleichrichters muss weiterhin von einem Analog-Digital-Wandler erfassbar sein. Der Analog-Digital-Wandler ist entweder Bestandteil des Mikrocontrollers oder Bestandteil eines Schaltwandler-IC's, der über eine digitale Kommunikationsverbindung seriell oder parallel mit dem Mikrokontroller verbunden ist, oder er ist Bestandteil des Endstufen-IC's und über eine digitale Kommunikationsverbindung seriell oder parallel mit dem Mikrokontroller verbunden.

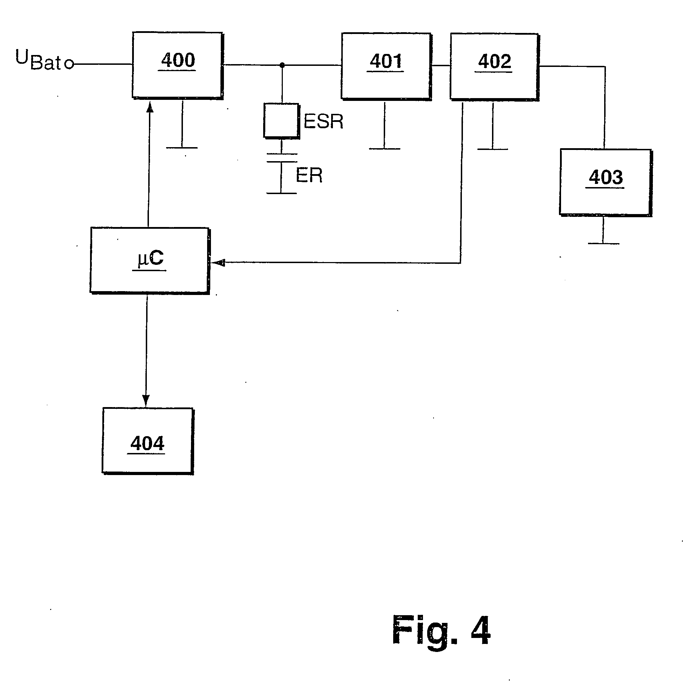

In Figur 4 ist in einem Blockschaltbild als eine Übersicht die erfindungsgemäße Vorrichtung dargestellt. Ein Spannungswandler 400 wandelt die Batteriespannung $U_{Bat}$ auf einen höheren Wert, mit dem ein nachgeschalteter Energiereservekondensator ER aufgeladen wird. Dieser Energiereservekondensator weist einen Innenwiderstand ESR auf, durch den der Ladestrom des Spannungswandlers 400 läuft. Dem Energiereservekondensator ER ist ein Gleichrichter 401 nachgeschaltet. Dieser Gleichrichter verhindert eine unbeabsichtigte Zündung durch einen ungewollten positiven Spannungsimpuls in der nachgeschalteten Zündeinrichtung 403 oder den Anschlüssen des Zündelements, da ohne diesen Gleichrichter 401 das Zündelement über die Rückwärtsdioden der Endstufentransistoren mit der Energiereserve verbunden wäre und daher bei einem Potenzialunterschied Strom führt. Zwischen dem Gleichrichter 401 und der Zündeinrichtung 403 ist parallel geschaltet ein Spannungsteiler 402, der auch als Tiefpass ausgebildet ist. Dieser Spannungsteiler 402 dient zur Messung des Innenwiderstandes ESR, wie er im Folgenden beschrieben wird. Die am Spannungsteiler 402 gemessene Spannung wird dem Mikrokontroller $\mu$C zugeführt, und zwar direkt in seinen Analog-Digital-Wandler. In Abhängigkeit vom damit bestimmten Wert des Innenwiderstandes ESR des Energiereservekondensators ER steuert der Mikrokontroller $\mu$C eine Anzeige 404 an, die anzeigt, ob der Innenwiderstand ESR einen so hohen Wert hat, dass ein Austausch des Airbagsteuergeräts, in dem sich der Energiereservekondensator ER befindet, notwendig ist. Diese Anzeige 404 kann eine Lampe im Armaturenbrett, eine Anzeige auf einem Bildschirm, eine gesprochene Aussage oder eine über Funk übermittelte Nachricht an einen Dienstleister sein.

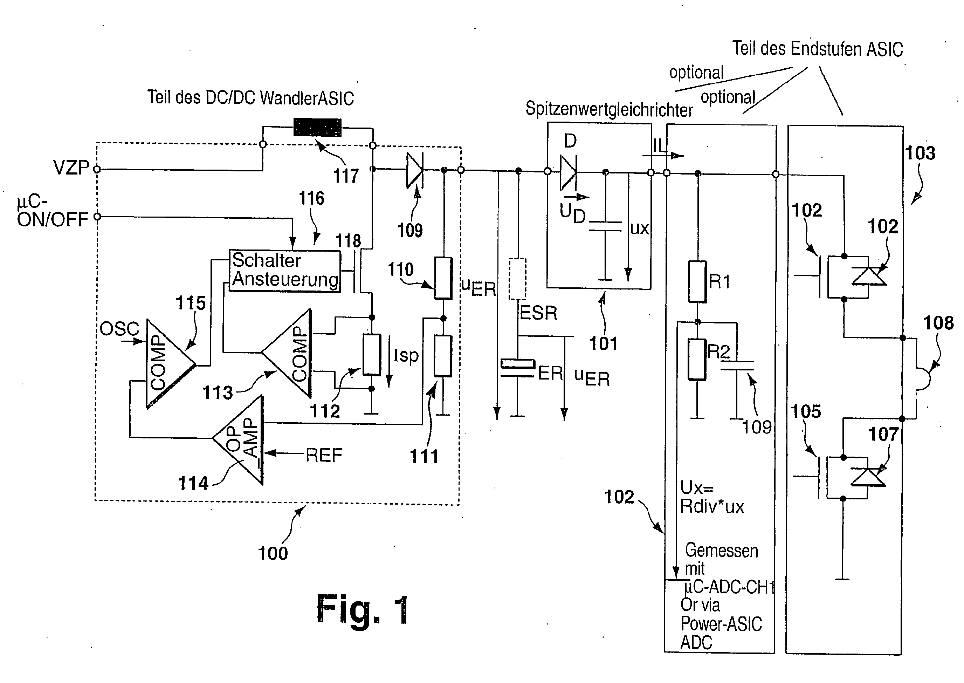

Figur 1 zeigt in einem Schaltbild die erfindungsgemäße Vorrichtung im Detail. Im Block 100 ist der Spannungswandler dargestellt. Eine Spule 117 ist außerhalb des Blocks 100 angeordnet, da alle Komponenten im Block 100 in einem IC integriert sind. Die Spule 117, die als Topfspule ausgebildet ist, kann nicht in den IC integriert werden. Die Spule 117 ist auf einer Seite mit der Batteriespannung $U_{Bat}$ bzw. mit der verpolgeschützten Batteriespannung VZP verbunden und auf der anderen Seite mit der Anode einer Diode 109 und beispielsweise dem Drainanschluss eines Transistors 118. Das Gate des Transistors 118 wird von einer Schalteransteuerung 116 angesteuert. Am Source-Anschluss des Transistors 118 ist ein erster Eingang eines Komparators 113 und ein Widerstand 112 angeschlossen. Auf der anderen Seite ist der Widerstand 112 mit Masse und dem zweiten Eingang des Komparators 113 verbunden. Die Kathode der Diode 109 ist einmal mit dem Widerstand 110 verbunden, und zum anderen außerhalb des IC's 100 mit dem Innenwiderstand des Elektrolytkondensators ESR und der Anode der Diode D eines Spitzenwertgleichrichters 101. Der Widerstand 101 ist auf seiner anderen Seite zum einen mit einem ersten Eingang eines Operationsverstärkers 114 und mit einem Widerstand 111 verbunden. Der Widerstand 111 ist auf der anderen Seite mit Masse verbunden. Damit bilden die Widerstände 110 und 111 einen Spannungsteiler. Der zweite Eingang des Operationsverstärkers 114 wird mit einer Referenzspannung beaufschlagt, so dass ein Vergleich der durch den Spannungsteiler 110 und 111 abgegriffenen Spannung und dieser Referenzspannung durch den Operationsverstärker 114 stattfindet. Der Ausgang des Operationsverstärkers 114 geht in einen ersten Eingang eines Komparators 115. An dem zweiten Eingang des Komparators 115 liegt ein Sägezahnsignal an. Der Ausgang des Komparators 115 geht in einen ersten Eingang der Schalteransteuerung 116. An einen zweiten Eingang der Schalteransteuerung 116 ist der Ausgang des Komparators 113 angeschlossen. An einen dritten Eingang der Schalteransteuerung 116 ist eine Signalleitung des Mikrocontrollers µC angeschlossen bzw die Kontrollleitung, die aufgrund von serieller oder paralleler Kommunikation zwischen Mikrokontroller und Schaltwandler IC den logischen Befehl Schaltwandler aktiv oder inaktiv an die Schalteransteuerung übermittelt.

Der Innenwiderstand ESR ist auf seiner anderen Seite mit der Kapazität ER des Energiereservekondensators verbunden. Die Kapazität ER ist auf der anderen Seite mit Masse verbunden. Der Innenwiderstand des Elektrolytkondensators ist kein elektrisches Bauelement, sondern die modellhafte Beschreibung für die ohmschen Verluste. Die Kathode der Diode D ist zum einen mit der Kapazität $C_{peak\_D}$ verbunden und mit dem Widerstand R1 und mit der Parallelschaltung aus dem Transistor 104 und der Kathode der Diode 106. Der Transistor 104 und die Kathode 106 gehören zum Endstufen-IC 103, der die Zündpille 108 ansteuert. Der Transistor 104 und die Diode 106 sind nämlich auf ihrer anderen Seite mit dem Zündelement 108 verbunden. Der Transistor 104 ist lediglich mit seiner Source und seinem Drain in die Schaltung integriert. Er wirkt hier als High-Side-Schalter. Die Beschaltung seines Gates ist hier der Einfachheit halber nicht dargestellt. Das Zündelement 108 ist auf der anderen Seite mit der Low-Side des Endstufen-ASIC's 103 verbunden, und zwar dabei mit der Drain eines Transistors 105 und der Kathode der Diode 107, die mit der Anode gegen Masse und der Drain des Transistors 105 verbunden ist. Der Widerstand R1 gehört zum Spannungsteiler 102, wobei der Widerstand R1 auf seiner anderen Seite mit dem Widerstand R2 und dem Kondensator 109 verbunden ist. Sowohl der Kondensator 109, als auch der Widerstand R2 sind auf der anderen Seite mit Masse verbunden.

Der Spannungswandler 100 setzt die Batteriespannung VZP auf einen höheren Wert um, um die Kapazität ER auf einen über der Batteriespannung liegenden Wert aufzuladen. Dabei funktioniert der Spannungswandler 100 im getakteten Zustand, d.h. im Ladezustand wird Energie in der Spule durch den wachsenden Spulenstrom bis $Isp_{max}$ im Querzweig durch den Schalttransistor 118 des Wandlers aufgebaut, um in der Sperrphase des Schalttransistors 118 als Ladestromimpuls an den Energiereservekondensator ER wieder abgebaut zu werden. Damit liegt ein sogenannter Sperrwandler vor.

Die Taktung des Spannungswandlers 100 erfolgt über das Oszillatorsignal OSC, das dem Komparator 115 zugeführt wird. Dieses wird moduliert in Bezug auf die Pulsweite durch die Rückkopplungsschleife aus dem Spannungsteiler 110 und 111 und dem Operationsverstärker 114, der die durch den Spannungsteiler 110 und 111 abgegriffene Spannung mit einem Referenzwert REF vergleicht. Damit wird eine Pulsweitenmodulation erreicht. Die Rückkopplung über den Komparator 113 dient zur Begrenzung des Spulenstroms in der Ladephase des Sperrwandlers auf einen Maximalwert. Die Diode 109 dient als Verpolschutz. Der Ladestrom $I_{SP}$ fließt demnach zum einen über den Innenwiderstand ESR und den Kondensator ER und zum anderen über die Diode D und lädt so die kleine Kapazität $C_{peak\_D}$ auf einen Spannungsspitzenwert auf, der über den Widerstand R1 und R2 abgegriffen werden kann.

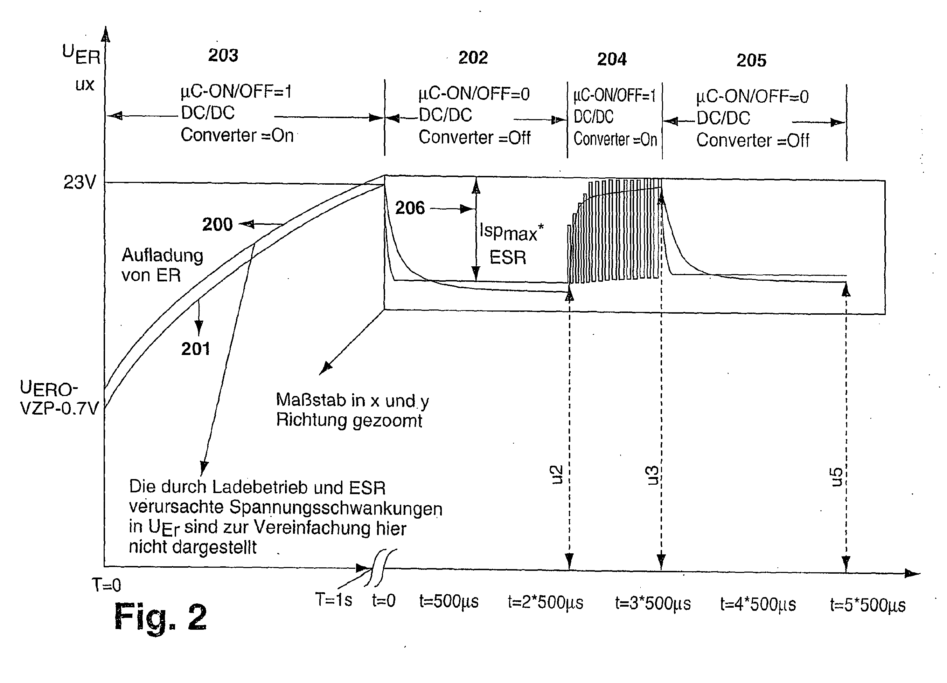

Die Bemessung der Widerstände R1 und R2 sowie des Kondensators 109 und des Kondensators $C_{peak\_D}$ erfolgt derart, dass der Ladestrom vorwiegend dem Kondensator ER zugeführt wird. Die High-Side 104 ist gesperrt und die Diode 106 ist derart geschaltet, dass sie den Ladestrom vom Wandler 100 sperrt. Wird der Spannungswandler 100 abgeschaltet und ist $U_{ER}$ > VZP, so fließt nach einem sehr kurzem Abklingen des Spulenstroms kein Ladestrom mehr in den Kondensator ER und der Spannungsabfall über dem Innenwiderstand ESR entfällt. Diesen Abfall zeigt auch die Spannung 201 in Fig. 2, Abschnitt 202 des nachgeschalteten Spitzenwertgleichrichters.

Die Spannung 201 = ux des Spitzenwertgleichrichters wird über den Spannungsteiler 102 bestehend aus R1 und R2 so geteilt und durch 109 so gefiltert gefiltert, daß er einem Analog Digital Converter eines Mikrokontrollers µC zur Spannungsmessung zuführbar ist.

Der Mikrokontroller kann aus dem beobachteten Abfall der Spannung am Spitzenwertgleichrichter und der Kenntnis des max. Spulenstromes den Innenwiderstand (ESR) des Energiereserve-Kondensators berechnen, wenn der Mikrokontroller andererseits Einfluß auf den Betrieb des Sperrwandlers nehmen kann und er genaue Kenntnis über die Größe der Batteriespannung $U_B$, (VZP) sowie der Energiereservespannung hat.

Figur 2 visualisiert die Messmethode in einem Spannungs-Zeit-Diagramm. Auf der Ordinate ist die Spannung 200 = $U_{ER}$ (Spannung am Energiereservekondensator einschließlich des Innenwiderstands gegen Masse) und 201=ux (Ausgangsspannung des Spitzenwertgleichrichters gegen Masse) aufgetragen und auf der Abszisse die Zeit. In einem ersten Abschnitt 203 ist der Spannungswandler 400 durch den Mikrokontroller µC angeschaltet, so dass es zu einer Aufladung des Kondensators ER über die Batteriespannung $U_B$ bzw. VZP kommt. Im Zeitabschnitt 202 wird dann durch den Mikrokontroller µC der Spannungswandler 400 abgeschaltet. Wegen des kleinen Spannungshubs und zur Verdeutlichung schneller Zeitvorgänge ist der Maßstab in Spannungs- und Zeitrichtung vergrößert (Zoom). Nunmehr, da kein Ladestrom mehr durch den Widerstand ESR fließt, entfällt der Spannungsabfall über diesem Widerstand. Dies geschieht jedoch nicht sofort, sondern mit einer gewissen Verzögerung wegen des Abklingens des Spulenstrom in bezug auf

200= $U_{ER}$ und der zusätzlichen Tiefpassfilterung im Spitzenwertgleichrichter in bezug auf 201= ux. Deshalb wird eine Zeit Toff gewartet, bis sich ein statischer Wert eingespielt hat. Dieser Wert wird hier in bezug auf 20 1 =ux mit u2 bezeichnet. Als Zeit Toff wurde hier eine Zeit von $\pm 2\cdot 0{,}5$ ms abgeschätzt.

Dann folgt eine Phase 204, in der der Spannungswandler im Rahmen der Energiereserve ESR-Messung eingeschaltet wird. Nunmehr ist deutlich die getaktete Aufladung des Kondensators ER dargestellt. Diese Zeit im Zeitabschnitt 204 ist hier 0,5 ms lang. Sie hat zur Folge, dass eine Aufladung des Spitzenwertgleichrichters auf den Wert u3 erfolgt, während UER diesen Wert nur gepulst um eine Diodenspannung sowie einer geringen Erhöhung des Spannungsgrundwerts der Energieservekapazität übertrifft.. In Fig. 2 ist dies 201 bzw. 200 im Abschnitt 204.

Auf den Zeitabschnitt 204 folgt der Zeitabschnitt 205, in dem wiederum der Spannungswandler abgeschaltet wird und sich die Spannung u5 am Ausgang des Spitzenwertgleichrichters nach einer Wartezeit von $2\cdot 0{,}5$ ms nach Abklingen aller Zeitkonstanten gegen Masse einstellt.

Die entsprechend linear geteilten Spannungen am Ausgang des Spannungsteiler 102 mit großem U gekennzeichnet (u2→U2, u3→U3, u5→U5) werden zur Berechnung des Innenwiderstandes (ESR) der Energiereserve an den ADC des Mikrokontrollers weitergegeben.

Die Spannung der Energiereserve wird zunächst durch Aufladung auf einen durch $U_{Bat}$ (VZP) nicht zu beeinflussenden Wert angehoben, beispielsweise 23 Volt, um von der Batterie unabhängig zu sein. Danach wird der Spannungswandler 400 ausgeschaltet und nach einer Wartezeit Toff die Spannung am Spitzenwertgleichrichter 401 gemessen. Die Wartezeit Toff ist so gewählt, dass die Energie in der Wandlerspule abgebaut ist und die undefinierte Spitzenspannung des Spitzenwertgleichrichters durch den definierten Eingangsstrom der verbundenen Endstufen und/oder durch die ohm'sche Belastung des Spannungsteilers auf die statische Spannung UER-UD abgesunken ist sowie $4\tau$ eines nachgeschalteten Tiefpassfilters vergangen sind, wobei $\tau$ die Zeitkonstante des Tiefpassfilters ist. Toff wurde beispielsweise mit 1 ms gewählt, das entspricht beispielsweise zwei Echtzeitrastern des Mikrocontrollers.

Eine Abschätzung von Toff ergibt sich zu Toff $\approx$ dt1 +dt2 + dt3:

Wandlerspule Lsp * $Isp^2$ = $C_{ER}$ * $(u_{ER}^2 - u_{ER0}^2)$, woraus folgt

$du_{ER}$ = 3.1 mV mit $C_{ER}$=2.2mF folgt daraus **dt1 = 5.7 $\mu$s**

Spitzenwertgleichrichter: $ESR_{max}$ * $Isp_{max}$ * $C_{peak\_D}$ / IL = dt2 = 800 $\mu$s

Tiefpaßfilter (gebildet aus 102 und 109 in Figur 1): $4\tau$ = **dt3 = 100 $\mu$s**

$$\textbf{Toff>=dt1+dt2+dt3=905,6\mu s gewählt Toff=2*0.5ms}$$

Berechnungsparameter: IL = 1,2 mA für die Versorgung des Endstufen-IC's am ER und dem Teiler sowie $ESR_{max}$ = 4 $\Omega$, $Isp_{max}$ = 1,2 A, $C_{peak\_D}$ = 200 nF, $u_{ER0}$ = 18 Volt, $C_{ER}$ = 2,2 mF, Lsp = 220 $\mu$H.

Dann erfolgt eine Betrachtung des Spannungsverlustes der Energiereserve in der Zeit Toff durch übliche statische Energiereservebelastungsströme.

Für eine Energiereserve der Kapazität $C_{ER}$ ergibt sich für einen Laststrom IL in der Zeit Toff folgende Spannungsänderung:

$$du_{ERoff} = 1L*Tw/C_{ER}.$$

Mit $C_{ER}$ = 2,2 mFm, IL = 1,2 mA, Tw = 1 ms, ergibt sich

$du_{ERoff}$= 1,2 mA * 1 ms/2,2 mF = 0,55 mV ergibt.

Das zeigt, das für übliche Energiereserven von 2,2 bis 20 mF $du_{ERoff}$ vernachlässigbar klein ist.

Im Folgenden wird die Gleichung für U2 angegeben:

$$\text{Glg.1}\quad U2=Ux(t=Toff)=Ux(t=2*500\mu s)= Rdiv*[u_{ER}(t=Toff)-U_D] =1449mV;$$

Berechnungsparameter:

Rdiv=R1/R1+R2=0.0833; $U_D$= 0.8V; zB. $u_{ER}$(t=Toff)=$U_{ER}$(t=0)-$Isp_{max}$*ESR=18.2V

falls $U_{ER}$(t=0)=23V bei Isp=$Isp_{max}$, $Isp_{max}$=1.2A und ESR=$ESR_{max}$=4$\Omega$

Dann wird der Wandler eingeschaltet und eine Zeit Ton betrieben. Ton wurde hier mit 500 $\mu$s gewählt. Ton ist

dabei so gewählt, dass die Energiereservespannung nahezu unverändert bleibt, aber der Spitzenwertgleichrichter auf den Wert durch einen Energiereserveinnenwiderstand verursachten Spannungsabfall angehoben wird.

Im Folgenden wird die Gleichung für U3 angegeben:

$$\text{Glg.2} \quad U3= Ux(t=Toff+Ton)= Ux(3*500\mu s)=Rdiv*[u_{ER}(t=Toff+Ton)+Isp_{max}*ESR-U_D]$$

$$\text{Glg.4} \quad ESR= (U3-U2)/(Rdiv*Isp_{max}),$$

unter folgender Vereinfachung $u_{ER}(t=Toff+Ton)\approx u_{ER}(t=Toff)$,

Die Ungenauigkeit dieser Vereinfachung kann durch folgende Methoden verbessert werden:
die weitere Aufladung der Energierserve in der Zeit Ton wird zunäcsht abgeschPatzt

die weitere Aufladung der Energiereserve in der Zeit Ton wird zunächst abgeschätzt

$$du_{ERon}\approx[(Isp_{max}/3) *500\mu s)]/C_{Ern} \text{ mit beispielsweise } Isp_{max}=1.2, C_{ERn}=2200\mu F$$

$$\text{ergibt sich } du_{ERon}=90mV$$

Dies führt zu einer verbesserten Bestimmung des Innenwidertands ESR. Folglich ist die Gleichung 4 folgendermaßen zu modifizieren:

$$\text{Glg.5 } ESR=(U3-d_{UERon}-U1)/(Rdiv*Isp_{max}) \text{ darin ist U1 unbekannt !}$$

**die Messung wird erweitert durch Hinzunahme des Meßwertes u5**

Nach Messung von U3 wird der Wandler ausgeschaltet. Erneut wird die Wartezeit Toff gewartet, bis der Spitzenwertmesser wieder die quasistatische Spannung UER-UD anzeigt, dann wird gemessen, und zwar u5 bzw. U5. Dadurch kann Gleichung 5 ohne die Unbekannte folgendermaßen ausgedrückt werden:

$$\text{Glg.6} \quad ESR=(U3-(U5-U1)-U1)/(Rdiv* Isp_{max}) = (U3-U5)/(Rdiv*Isp_{max})$$

Als Toleranz zur Bestimmung des Innenwiderstands verbleiben

aa) die Toleranz der Spannungsmessung, die im Wesentlichen nur durch den Spannungsteiler gegeben ist. Die Referenzspannung des Analog-Digital-Wandlers geht wegen der schnellen Messfolge nicht ein, sofern diese ausreichend gefiltert wird.
bb) eine $\pm 1$ bit Toleranz des Analog-Digital-Wandlers entspricht bei einem 10-Bit-Analog-Digital-Wandler mit einer Referenzspannung von 3,3 V bezogen auf die Mess-Spannung Ux einem Wert von 3 8,76 mV
cc) die Toleranz des maximalen Spulenstroms $ISP_{max}$. Dieser kann durch geeignetes Design des Schaltreglers einfach bei $\pm$ 33% gehalten werden oder durch Abgleich zum Beispiel über einen Referenzwiderstand auf höchste Genauigkeit gebracht werden beispielsweise 3%.

Der Spitzenwertgleichrichter bestehend aus der Diode D und der Kapazität $C_{peak\_D}$ sind notwendige Bauelemente für die Bestimmung des Innenwiderstands der Energiereserve nach dem oben beschriebenen Verfahren. Die Bauelemente sind aber in der Regel bereits Bestandteil eines Airbagsteuergeräts, um den Verpolschutz der Zündkreise bei Kurzschluss nach $U_{Bat}$ gegen die Energiereserve zu ermöglichen.

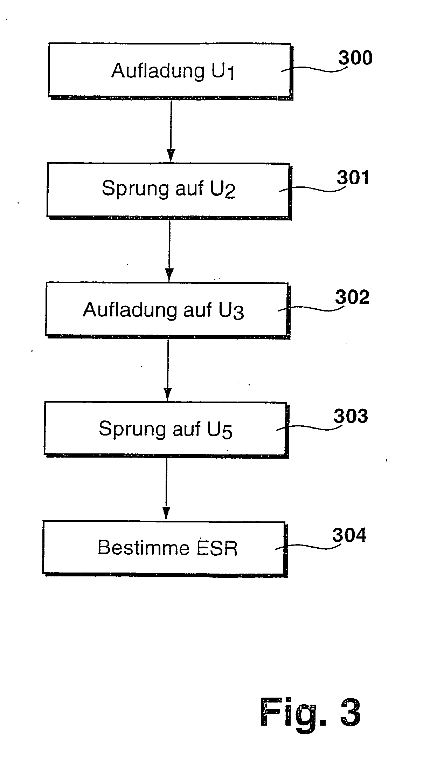

Figur 3 zeigt in einem Flussdiagramm das erfindungsgemäße Verfahren. Bei Verfahrensschritt 300 erfolgt die Aufladung auf den oben genannten Wert von zB.

$U_{ER}$=23 Volt (≈$u_{ER}$ falls ESR≈0). $u_{ER}$> $U_{Bmax}$ gewählt.

Am ADC des Mikrokontrollers erreicht ux den Wert U1. In Verfahrensschritt 301 wird der Wandler abgeschaltet und der Strom fällt auf Null, so dass die Spannung aufU2 absinkt. In Verfahrensschritt 302 erfolgt dann wiederum der Ladebetrieb von ER, wobei sich die Spannung am Spitzenwertgleichrichter 101,401 auf u3 auflädt bzw. U3 am ADC Eingang, um wiederum in Verfahrensschritt 303 den Wandler abzuschalten, so dass wiederum das Absinken auf U5 erfolgt. Aus den Spannungsdifferenzen unter Berücksichtigung der übrigen elektrischen Parameter kann in Verfahrensschritt 304 dann der Innenwiderstand des Energiereservekondensators bestimmt werden.

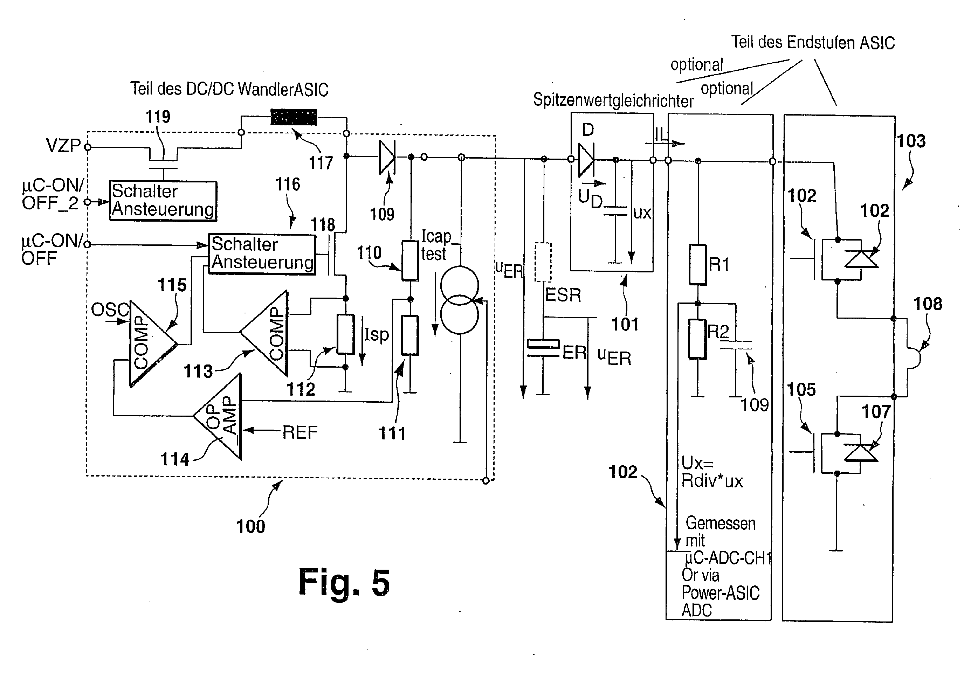

In Figur 5 ist ein weiteres Ausführungsbeispiel einer kombinierten ESR und Kapazitätsmessung einer zentralen Energiereserve dargestellt.

Figur 1 wurde dabei zunächst um einen weiteren Längstransistor 119 erweitert. Der Längstransistor 119 ist mit einer Außenelektrode mit der Batteriespannung VZP und mit der anderen Außenelektrode mit der Spule 117 verbunden. Die Mittelelektrode ist mit einer Schalteransteuerung 120 verbunden. Die Schalteransteuerung 120 wird durch den Mikrocontroller μC gesteuert. Der Längstransistor 119 ist damit im Vergleich zur Fig. 1 in die Verbindungsleitung zwischen VZP und der Spule 117 eingefügt. Ansonsten sind alle Bauelemente und Verbindungen gleich.

Durch diesen Transistor 119 kann der Durchgriff der Batteriespannung auf die Energiereserve vom μC gesteuert werden.

Ist der Transistor 119 ausgeschaltet, so kann die Energiereserve auch nicht durch UB (VZP) vorgeladen werden.

Ist der Transistor 119 eingeschaltet, wird die ER auf UB (VZP) vorgeladen.

Danach kann die Energiereserve durch die hinzugenommene Stromquelle ohne Störung durch UB bei niedriger ER Spannung zur Kapazitätsmessung etwas entladen werden.

Aus Icap_test, der gewählten Entladezeit und dem beobachteten Spannungshub an ER läßt sich die Kapazität der ER berechnen.

Vorteile dieses Ausführungsbeispiels sind μC gesteuerte Vorladung der ER auf UB (VZP).

Ein ER-Kapazitäts-Test bei niegriger ER-Spannung führt zur Reduktion der Verlustleistung in der Meßstromquelle zur Kapazitätsmessung.

Die ER-Kapazitätsmessung und ESR-Messung lassen sich bei gesperrtem Längstransistor ohne Störung durch Transienten auf der Versorgungsleitung durchführen, da der Durchgriff der UB (VZP) während der Messungen unterbunden wird.

Die μC-Steuerleitungen μC-ON/OFF, μC-ON/OFF_2, μC-ON/OFF_3 können neben der direkten Verbindung zum μC, auch aus einer auf dem ASIC vorhandenen Logik gesteuert werden, wobei diese über eine serielle oder parallele Schnittstelle mit dem μC kommuniziert, um die Befehle zu empfangen bzw. deren Ausführung zu quittieren

## Patentansprüche

1. Vorrichtung zur Überwachung wenigstens eines Energiereservekondensators (ER) in einem Rückhaltesystem, wobei die Vorrichtung zur Überwachung des Ohmschen Innenwiderstandes (ESR) des wenigstens einen Energiereservekondensators (ER) konfiguriert ist, und wobei die Vorrichtung zur Überwachung der Kapazität des wenigstens einen Energiereservekondensators (ER) konfiguriert ist, **dadurch gekennzeichnet, dass** die Vorrichtung zur Überwachung des Innenwiderstands (ESR) einen Spannungswandler (400) aufweist, der den wenigstens einen Energiereservekondensator auf einen ersten Spannungswert (u1) über der Autobatteriespannung auflädt, wobei der Spannungswandler (400) derart mit einem Mikrocontroller (μc) verbunden ist, dass von dem Spannungswandler (400) in Abhängigkeit von einem Signal des Mikrocontrollers (μc) der wenigstens eine Energiereservekondensator (ER) getaktet auf einen zweiten Spannungswert (u3) aufladbar ist, wobei ein Spitzenwertgleichrichter vorgesehen ist, der den zweiten Spannungswert erfasst, wobei die Spannung am Spitzenwertgleichrichter nach dem getakteten Aufladen auf den dritten Spannungswert (u5) absinkt und dass von dem Mikrocontroller (μc) der Innenwiderstand in Abhängigkeit von einer Spannungsdifferenz des zweiten und dritten Spannungswertes (u3, u5) bestimmbar ist.

2. Vorrichtung nach Anspruch 1, **dadurch gekennzeichnet, dass** die Vorrichtung derart konfiguriert ist, dass die Vorrichtung durch eine zeitliche Abfolge wenigstens eines Ladevorgangs (204) und einer Unterbrechung des Ladevorgangs (205) des Energiereservekondensators (ER) den Innenwiderstand (ESR) bestimmt.

3. Vorrichtung nach Anspruch 1 oder 2, **dadurch gekennzeichnet, dass** zur Überwachung des Innenwiderstands (ESR) ein mit dem Spannungswandler (100, 400), verbundener Spannungsteiler (402, 102) vorgesehen ist.

4. Vorrichtung nach Anspruch 3, **dadurch gekennzeichnet, dass** der Spannungswandler (100, 400) eine Regelung für seine Ausgangsspannung aufweist.

5. Vorrichtung nach Anspruch 3, **dadurch gekennzeichnet, dass** der Spannungsteiler (102, 402) als Tiefpass konfiguriert ist.

6. Vorrichtung nach einem der vorhergehenden Ansprüche, **dadurch gekennzeichnet, dass** im Spannungswandler (100, 400) ein Längstransistor (119) vorgesehen ist, der einen Durchgriff der Batteriespannung (VZP) auf den Energiereservekondensator (ER) steuert.

7. Verfahren zur Überwachung wenigstens eines Energiereservekondensators (ER) in einem Rückhaltesystem, wobei der Innenwiderstand (ESR) des wenigstens einen Energiereservekondensators (ER) überwacht wird, und wobei die Kapazität (ER) des wenigstens einen Energiereservekondensators überwacht wird, **dadurch gekennzeichnet, dass** der Innenwiderstand (ESR) dadurch überwacht wird, dass in einem ersten Schritt der Energiereservekondensator (ER) auf einen ersten Spannungswert (23 Volt) über der Autobatteriespannung aufgeladen wird, dass in einem zweiten Schritt die Aufladung für eine erste Zeit (Toff) unterbrochen wird, dass in einem dritten Schritt für eine zweite Zeit (Ton) der Energiereservekondensator (ER) wieder für die zweite Zeit (Ton) auf einen zweiten Spannungswert (u3) getaktet geladen wird, wobei ein Spitzenwertgleichrichter (101, 401) den zweiten Spannungswert (u3) erfasst, dass in einem vierten Schritt die Aufladung für eine dritte Zeit (Toff) unterbrochen wird, so dass die Spannung am Spitzenwertgleichrichter auf einen dritten Spannungswert (u5) absinkt, und dass in einem fünften Schritt aus der Spannungsdifferenz aus dem zweiten und dritten Spannungswert (u5, u3) der Innenwiderstand (ESR) bestimmt wird.

8. Verfahren nach Anspruch 7 **dadurch gekennzeichnet, dass** der Innenwiderstand mittels einer zeitlichen Abfolge von wenigstens einem Ladevorgang und einer Unterbrechung des Ladevorgangs bestimmt wird.

9. Verfahren nach einem der Ansprüche 7 oder 8 **dadurch gekennzeichnet, dass** die erste Zeit in Abhängigkeit von einer Zeitkonstanten eines dem Energiereservekondensators (ER) nachgeschalteten Tiefpasses (102, 402) und von einem Spannungsabbau eines Energiereservekondensators (ER) nachgeschalteten Gleichrichters (101, 401) gewählt wird.

10. Verfahren nach Anspruch 9 **dadurch gekennzeichnet, dass** die zweite Zeit derart gewählt wird, dass der Spitzenwertgleichrichter (101, 401) auf den zweiten Spannungswert (u3) angehoben wird.

11. Verfahren nach einem der Ansprüche 7 bis 10, **dadurch gekennzeichnet, dass** die dritte Zeit (Toff) gleich der ersten Zeit gewählt wird.

## Claims

1. Apparatus for monitoring at least one energy reserve capacitor (ER) in a restraint system, with the apparatus being designed to monitor the electrical internal resistance (ESR) of the at least one energy reserve capacitor (ER), and with the apparatus being designed to monitor the capacitance of the at least one energy reserve capacitor (ER), **characterized in that** the apparatus has a voltage converter (400) for monitoring the internal resistance (ESR), which voltage converter charges the at least one energy reserve capacitor to a first voltage value (u1) above the car battery voltage, with the voltage converter (400) being connected to a microcontroller ($\mu$c) in such a way that the at least one energy reserve capacitor (ER) can be charged to a second voltage value (u3) in a pulsed manner by the voltage converter (400) as a function of a signal from the microcontroller ($\mu$c), with a peak value rectifier being provided which detects the second voltage value, with the voltage across the peak value rectifier dropping to the third voltage value (u5) after pulsed charging, and **in that** the internal resistance can be determined by the microcontroller ($\mu$c) as a function of a voltage difference between the second and third voltage values (u3, u5).

2. Apparatus according to Claim 1, **characterized in that** the apparatus is designed in such a way that the apparatus determines the internal resistance (ESR) on account of a time sequence of at least one charging process (204) and an interruption in the charging process (205) of the energy reserve capacitor (ER).

3. Apparatus according to Claim 1 or 2, **characterized in that** a voltage divider (402, 102) which is connected to the voltage converter (100, 400) is provided for monitoring the internal resistance (ESR).

4. Apparatus according to Claim 3, **characterized in that** the voltage converter (100, 400) has a closed-loop control system for its output voltage.

**5.** Apparatus according to Claim 3, **characterized in that** the voltage divider (102, 402) is designed as low-pass filter.

**6.** Apparatus according to one of the preceding claims, **characterized in that** a series transistor (119) is provided in the voltage converter (100, 400), which series transistor controls passage of the battery voltage (VZP) to the energy reserve capacitor (ER).

**7.** Method for monitoring at least one energy reserve capacitor (ER) in a restraint system, with the internal resistance (ESR) of the at least one energy reserve capacitor (ER) being monitored, and with the capacitance (ER) of the at least one energy reserve capacitor being monitored, **characterized in that** the internal resistance (ESR) is monitored by the energy reserve capacitor (ER) being charged to a first voltage value (23 volts) above the car battery voltage in a first step, by charging being interrupted for a first time (Toff) in a second step, by the energy reserve capacitor (ER) being charged again in a pulsed manner to a second voltage value (u3) for a second time (Ton) in a third step, with a peak value rectifier (101, 401) detecting the second voltage value (u3), by charging being interrupted for a third time (Toff) in a fourth step, with the result that the voltage across the peak value rectifier drops to a third voltage value (u5), and by the internal resistance (ESR) being determined from the voltage difference between the second and third voltage values (u3, u5) in a fifth step.

**8.** Method according to Claim 7, **characterized in that** the internal resistance is determined using a time sequence of at least one charging process and an interruption in the charging process.

**9.** Method according to either of Claims 7 and 8, **characterized in that** the first time is selected as a function of a time constant of a low-pass filter (102, 402) which is connected downstream of the energy reserve capacitor (ER) and as a function of a voltage reduction in a rectifier (101, 401) which is connected downstream of an energy reserve capacitor (ER).

**10.** Method according to Claim 9, **characterized in that** the second time is selected in such a way that the peak value rectifier (101, 401) is raised to the second voltage value (u3).

**11.** Method according to one of Claims 7 to 10, **characterized in that** the third time (Toff) is selected to be equal to the first time.

**Revendications**

**1.** Dispositif de surveillance d'au moins un condensateur de réserve d'énergie (ER) dans un système de retenue, configuré pour surveiller la résistance ohmique intérieure (ESR) d'au moins un condensateur de réserve d'énergie (ER) et la capacité d'au moins un condensateur de réserve d'énergie (ER),
**caractérisé en ce que**
le dispositif de surveillance de la résistance intérieure (ESR) présente un convertisseur de tension (400) qui charge au moins un condensateur de réserve d'énergie à une première valeur de tension (u1) au-dessus de la tension de la batterie de la voiture, le convertisseur de tension (400) étant relié à un microcontrôleur (μc) de manière à ce que le convertisseur de tension (400) puisse charger le condensateur de réserve d'énergie (ER) de manière cadencée à une deuxième valeur de tension (u3) en fonction d'un signal du microcontrôleur (μc), un détecteur de crête détecte la deuxième valeur de tension, la tension sur le détecteur de crête baissant à la troisième valeur de tension après la charge cadencée, et
le microcontrôleur (μc) peut déterminer la résistance intérieure en fonction d'une différence de tension entre la deuxième et la troisième valeur de tension (u3, u5).

**2.** Dispositif selon la revendication 1,
**caractérisé en ce que**
il est configuré pour déterminer la résistance intérieure (ESR) grâce à une succession dans le temps d'au moins un processus de charge (204) et d'une interruption du processus de charge (205) du condensateur de réserve d'énergie (ER).

**3.** Dispositif selon la revendication 1 ou la revendication 2,
**caractérisé par**
un diviseur de tension (402, 102) relié au convertisseur de tension (100, 400) pour surveiller la tension intérieure (ESR).

**4.** Dispositif selon la revendication 3,
**caractérisé en ce que**
le convertisseur de tension (100, 400) présente un réglage pour sa tension de sortie.

**5.** Dispositif selon la revendication 3,
**caractérisé en ce que**
le diviseur de tension (102, 402) est un passe-bas.

**6.** Dispositif selon l'une quelconque des revendications précédentes,
**caractérisé en ce que**
dans le diviseur de tension (100, 400) un transistor à passage longitudinal (119) commande la pénétrabilité de la tension de la batterie (VZP) sur le condensateur de réserve d'énergie (ER).

**7.** Procédé de surveillance d'au moins un condensateur de réserve d'énergie (ER) dans un système de retenue, selon lequel on surveille la résistance ohmique intérieure (ESR) d'au moins un condensateur de réserve d'énergie (ER) et la capacité d'au moins un condensateur de réserve d'énergie (ER),
**caractérisé en ce qu'**
on surveille la résistance intérieure (ESR) en chargeant, au cours d'une première étape, le condensateur de réserve d'énergie (ER) à une première valeur de tension (23 volts) au-dessus de la tension de la batterie de la voiture, au cours d'une deuxième étape, la charge est interrompue pour un premier temps (Toff), au cours d'une troisième étape, le condensateur de réserve d'énergie (ER), pour un deuxième temps (Ton), est rechargé à une deuxième valeur de tension (u3) pour ce deuxième temps (Ton), un détecteur de crête (101, 401) détectant la deuxième valeur de tension (u3), au cours d'une quatrième étape, la charge est interrompue pour un troisième temps (Toff) de manière à ce que la tension chute à une troisième valeur de tension (u5) au niveau du détecteur de crête et, au cours d'une cinquième étape, on détermine la résistance intérieure (ESR) à partir de la tension différentielle entre la deuxième et la troisième valeur de tension (u5, u3).

**8.** Procédé selon la revendication 7,
**caractérisé en ce qu'**
on détermine la résistance intérieure au moyen d'une succession dans le temps d'au moins un processus de charge et d'une interruption du processus de charge.

**9.** Procédé selon l'une quelconque des revendications 7 ou 8,
**caractérisé en ce qu'**
on choisit le premier temps en fonction d'une constante de temps d'un passe-bas (102, 402) placé en aval du condensateur de réserve d'énergie (ER) et d'une baisse de la tension d'un redresseur (101, 401) placé en aval d'un condensateur de réserve d'énergie (ER).

**10.** Procédé selon la revendication 9,
**caractérisé en ce qu'**
on choisit le deuxième temps de manière à relever le détecteur de crête (101, 401) à la deuxième valeur de tension (u3).

**11.** Procédé selon l'une quelconque des revendications 7 à 10,
**caractérisé en ce qu'**
on choisit le troisième temps (Toff) égal au premier temps.

Fig. 1

**Fig. 2**

EP 1 622 795 B1

$$\boxed{\text{Aufladung } U_1} \quad 300$$

$$\downarrow$$

$$\boxed{\text{Sprung auf } U_2} \quad 301$$

$$\downarrow$$

$$\boxed{\text{Aufladung auf } U_3} \quad 302$$

$$\downarrow$$

$$\boxed{\text{Sprung auf } U_5} \quad 303$$

$$\downarrow$$

$$\boxed{\text{Bestimme ESR}} \quad 304$$

# Fig. 3

U$_{Bat}$ o

400

ESR

ER

401

402

403

μC

404

**Fig. 4**

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19715571 A1
- DE 10118299 A1
- DE 20005783 U1